(19) Europäisches Patentamt
European Patent Office
Office européen des brevets

(11) Numéro de publication: 0 249 287
A1

(12) **DEMANDE DE BREVET EUROPEEN**

(21) Numéro de dépôt: 87201073.1

(22) Date de dépôt. 09.06.87

(51) Int. Cl.³: **H 03 K 19/094**
**H 03 F 3/45**

(30) Priorité: 10.06.86 FR 8608369

(43) Date de publication de la demande:
16.12.87 Bulletin 87/51

(84) Etats contractants désignés:
DE FR GB IT

(71) Demandeur: **Laboratoires d'Electronique et de Physique Appliquée L.E.P.**
**3, Avenue Descartes**
**F-94450 Limeil-Brévannes(FR)**

(84) Etats contractants désignés:
**FR**

(71) Demandeur: **N.V. Philips' Gloeilampenfabrieken**
**Groenewoudseweg 1**
**NL-5621 BA Eindhoven(NL)**

(84) Etats contractants désignés:
**DE GB IT**

(72) Inventeur: **Ducourant, Thierry Société Civile S.P.I.D.**
**209, rue de l'Université**
**F-75007 Paris(FR)**

(74) Mandataire: **Landousy, Christian et al,**
**Société Civile S.P.I.D. 209, Rue de l'Université**
**F-75007 Paris(FR)**

(54) **Circuit amplificateur différentiel régénérateur de signaux complémentaires de faible amplitude.**

(57) Circuit amplificateur différentiel régénérateur de signaux complémentaires analogiques de faible amplitude, incluant:
- une paire différentielle de transistors à effet de champ $(T_1, T_2)$ dont les sources communes sont connectées à une première tension d'alimentation $V_{SS}$ à travers une charge $(R_3)$;
- une paire de charges $(R_1, R_2)$ connectées respectivement au drain de chaque transistor de la paire différentielle $(T_1, T_2)$ et à une seconde alimentation $(v_{DD})$;
- un circuit régérateur de niveau comprenant une paire de diodes $(D_1, D_2)$ prelevant les signaux respectivement au drain de chaque transistor de la paire différentielle $(T_1, T_2)$, caractériséen ce que les signaux transportés par les diodes $(D_1, D_2)$ sont appliqués respectivement sur le transistor bas $(T_{10}, T_{20})$ d'une paire d'étages PUSH-PULL, dont le transistor haut $(T_{11}, TR_1)$ reçoit directement le signal prélevé sur le drain du transistor opposé de la paire différentielle $(T_1, T_2)$, la source des transistors bas $(T_{10}, T_{20})$ des étages PUSH-PULL étant portée à la masse et le drain du transistor haut $(T_{11}, TR_1)$ de ces étages étant porté au second potentiel d'alimentation $V_{DD}$, les sorties complémentaires amplifiées étant disponibles aux points milieux (11,21) des étages PUSH-PULL.

Application: régénération de signaux complémentaires analogiques de faible amplitude et de valeur continue moyenne va-riable pour mémoires statiques.

FIG.1

CIRCUIT AMPLIFICATEUR DIFFERENTIEL REGENERATEUR DE SIGNAUX COMPLEMENTAIRES DE FAIBLE AMPLITUDE

L'invention concerne un circuit amplificateur différentiel régénateur de signaux complémentaires analogiques de faible amplitude, incluant :

- une paire différentielle de transistors à effet de champ dont les sources communes sont connectées à une première tension d'alimentation à travers une charge ;

- une paire de charges connectées respectivement au drain de chaque transistor de la paire différentielle et à une seconde alimentation ;

- un circuit régérateur de niveau comprenant une paire de diodes prélevant les signaux respectivement au drain de chaque transistor de la paire différentielle.

L'invention trouve son application dans la régénération de signaux complémentaires analogiques de faible amplitude et de valeur continue moyenne variable, pour mémoires statiques à moyenne et forte densité d'intégration, en technologie de circuits intégrés sur arséniure de gallium GaAs.

Un tel circuit amplificateur différentiel est connu de l'état de la technique par la demande de brevet européen 0 154 501. Ce document décrit un circuit amplificateur différentiel comprenant une paire différentielle de transistors à effet de champ dont les sources couplées sont portées à un potentiel continu à travers une source de courant. Les drains des transistors de la paire différentielle sont portés à une seconde tension d'alimentation continue à travers une paire de charges. D'autre part, chaque drain est relié à l'autre à travers une diode. Le but de ce circuit connu est de diminuer l'instabilité du niveau bas, d'augmenter le gain, de maintenir une faible consommation et une réponse rapide.

Mais un tel circuit n'est pas apte à fournir des sorties dont le niveau moyen est fixe, quelles que soient les entrées. De plus les sorties sont très dépendantes des charges capacitives. C'est pourquoi un tel circuit est essentiellement appliqué à un second circuit différentiel.

Mais pour l'application envisagée aux mémoires statiques, les sorties d'un tel amplificateur différentiel doivent être rigoureusement complémentaires, calibrées en amplitude et surtout en valeur absolue, ainsi qu'en temps de commutation, et de plus directement compatibles avec la logique dite DCFL (Direct Coupled FET Logic). Cela signifie que non seulement la différence entre le niveau haut et le niveau bas en sortie doit être constante quels que soient les niveaux d'entrée, mais encore la valeur moyenne de cette différence doit être rigoureusement à un niveau fixe quel que soit le niveau de la valeur moyenne de la différence des niveaux d'entrée. En effet, dans les mémoires, la valeur moyenne de la différence entre les niveaux hauts et les niveaux bas est souvent flottante. Ces signaux sont alors inutilisables pour un traitement ultérieur, car ils conduisent à des indéterminations. De plus l'obtention d'un gain élevé est nécessaire car les signaux issus des mémoires sont souvent de faible amplitude. Enfin le circuit envisagé doit être insensible aux charges capacitives.

Selon l'invention ces problèmes sont résolus au moyen d'un circuit tel que décrit dans le préambule, caractérisé en ce que les signaux transportés par les diodes sont appliqués respectivement sur le transistor bas d'une paire d'étages PUSH-PULL, dont le transistor haut reçoit directement le signal prélevé sur le drain du transistor opposé de la paire différentielle, la source des transistors bas des étages PUSH-PULL étant portée à la masse et le drain du transistor haut de ces étages étant porté au second potentiel d'alimentation, les sorties complémentaires amplifiées étant disponibles aux points milieux des étages PUSH-PULL.

Le circuit selon l'invention présente alors entre autres les avantages suivants :

- les sorties sont rigoureusement complémentaires,

- les niveaux logiques internes ont une très bonne marge de bruit,

- l'étage PUSH-PULL permet de supporter de fortes charges capacitives,

- les niveaux logiques de sortie sont parfaitement calibrés en amplitude et en valeur absolue. Le niveau moyen de leur différence est fixe et indépendant du niveau moyen de la différence des niveaux logiques d'entrée,

- les sorties de l'amplificateur différentiel sont chargées par la capacité d'une diode et d'un transistor à effet de champ en série, c'est-à-dire par une faible capacité,

- ce circuit est compatible avec la logique DCFL.

L'invention sera mieux comprise à l'aide de la description suivante illustrée par les figures annexées dont :

- la figure 1 qui représente le schéma du circuit selon l'invention,

- la figure 2 qui représente le séquencement des signaux dans ce circuit.

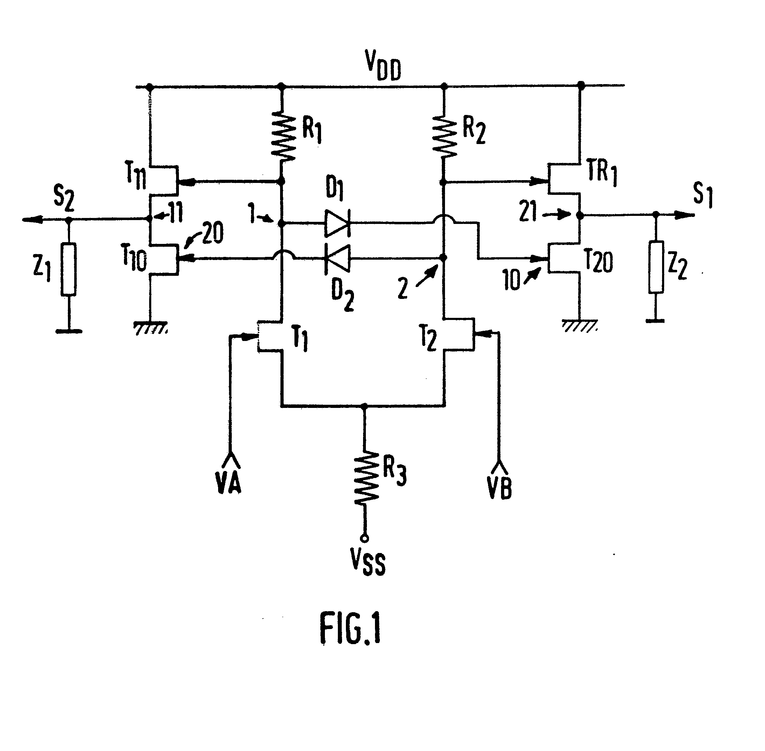

Tel que représenté sur la figure 1, le circuit amplificateur différentiel selon l'invention comprend une paire différentielle de transistors à effet de champ $T_1$ et $T_2$, dont les sources couplées sont portées à une première tension d'alimentation continue $V_{SS}$ à travers une charge $R_3$.

La grille du transistor $T_1$ est commandée par une première tension $V_A$ et la grille du transistor $T_2$ par une seconde tension $V_B$.

Les drains des transistors $T_1$ et $T_2$ de la paire différentielle sont reliés à une seconde tension d'alimentation continue $V_{DD}$ par l'intermédiaire de charges, respectivement $R_1$ et $R_2$.

Le circuit selon l'invention comprend en outre une paire d'étages PUSH-PULL. Le premier de ces étages PUSH-PULL est constitué du transistor bas $T_{10}$ dont la source est reliée à la masse, et du transistor haut $T_{11}$ dont le drain est

0249287

relié à la seconde tension d'alimentation $V_{DD}$. Le transistor bas $T_{10}$ de cet étage PUSH-PULL est commandé par le signal prélevé sur le drain du second transistor $T_2$ à travers au moins une diode, $D_2$. Le transistor haut $T_{11}$ de ce même étage PUSH-PULL est commandé par le signal prélevé directement sur le drain du premier transistor $T_1$ de la paire différentielle.

Le second étage PUSH-PULL est constitué du transistor bas $T_{20}$ dont la source est reliée à la masse, et du transistor haut $T_{21}$ dont le drain est relié à la seconde tension d'alimentation $V_{DD}$. Le transistor bas $T_{20}$ est commandé par le signal prélevé sur le drain du premier transistor $T_1$ de la paire différentielle à travers au moins une diode, ici $D_1$. Le transistor haut $T_{21}$ est commandé par le signal prélevé sur le drain du second transistor $T_2$ de la paire différentielle, directement.

D'une façon préférentielle, le circuit est réalisé à l'aide de transistors à effet de champ du type MESFET (Metal, Semi-insulating FET) normalement pincés en l'absence de signal grille-source, sur un substrat en arséniure de gallium (GaAs).

Les charges $R_1$, $R_2$, $R_3$ sont des résistances réalisées dans la zone active formée au cours de la mise en oeuvre des MESFET'S.

Les sorties du dispositif se font aux noeuds 11 et 21, respectivement aux points milieux du premier et du second étage PUSH-PULL, sur des charges $Z_1$ et $Z_2$.

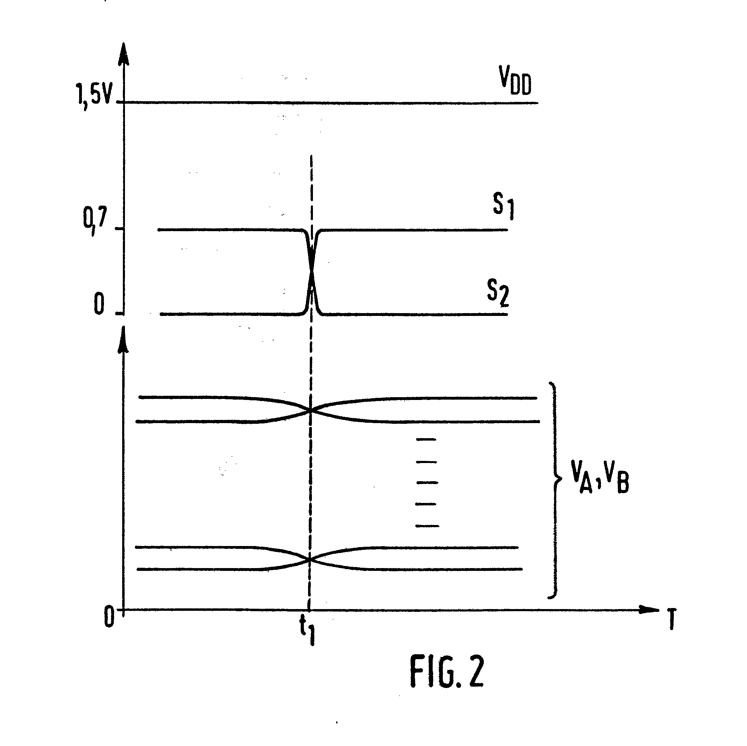

Tel qu'illustré par la figure 2, lorsque la tension $V_B$ est supérieure à la tension $V_A$ en entrée, le transistor $T_2$ de la paire différentielle est beaucoup plus passant que le transistor $T_1$. Le signal au noeud 2 (voir figure 1) sur le drain du transistor $T_2$ est donc à un niveau bas alors que le signal au noeud 1 sur le drain du transistor $T_1$ est proche de la valeur de la seconde alimentation continue $V_{DD}$, donc à un niveau haut.

Dans ces conditions le noeud 10 se polarise automatiquement à la tension d'écrêtage de la diode $D_1$ et met le

transistor bas $T_{20}$ du second étage PUSH-PULL en état de forte conduction. La diode $D_1$ conduit et accuse à ses bornes une chute de potentiel égale à sa tension d'écrêtage. Par contre, les signaux aux noeuds 2 et 20, c'est-à-dire respectivement au drain du second transistor $T_2$ de la paire différentielle et à la grille du transistor bas du premier étage PUSH-PULL sont proches de $\underline{0}$, bloquant le transistors $T_{11}$ et $T_{21}$. La diode $D_2$ ne conduit pas.

Le transistor haut du premier étage PUSH-PULL impose donc dans la charge $Z_1$ l'état logique $\underline{1}$, alors qu'au même instant, le transistor haut du second étage PUSH-PULL $T_{21}$ impose dans $Z_2$ l'état $\underline{0}$.

Lorsque le circuit selon l'invention est réalisé au moyen des transistors MESFET déjà cités, dans un exemple de réalisation :

- la tension d'alimentation continue $V_{DD} = 1,4V$
- la tension d'alimentation continue $V_{SS}$ peut être choisie parmi les valeurs -1,4 V et la masse (OV) ;
- la tension d'écrêtage des diodes est environ 0,7V ;
- les niveaux logiques internes ont donc une amplitude de 1,4V ce qui leur confère une bonne marge de bruit ;
- les niveaux de sortie sont calibrés sur 0, et 0,7V avec une valeur moyenne fixée à 0,350V quels que soient les niveaux d'entrée de $V_A$ et $V_B$.

Les transistors MESFET présentent de préférence une largeur de grille $L = 20\ \Omega$
et une tension de pincement $V_T = 50$ mV

La valeur des charges résistives est :

$R_1 = R_2 = 2\ K\Omega$

$R_3 = 1\ K\Omega$

$Z_1 = Z_2 = 2\ K\Omega$

Les capacités de sortie du circuit sont équivalentes à la capacité d'une diode, $D_1$ ou $D_2$ en série avec la capacité du transistor bas de l'étage PUSH-PULL correspondant, c'est-à-dire une faible capacité environ inférieure à 10 fF.

0249287
PHF 86/552 EP

REVENDICATIONS :

1.        Circuit amplificateur différentiel régénateur de signaux complémentaires analogiques de faible amplitude, incluant :

   - une paire différentielle de transistors à effet de champ dont les sources communes sont connectées à une première tension d'alimentation $V_{SS}$ à travers une charge ;

   - une paire de charges connectées respectivement au drain de chaque transistor de la paire différentielle et à une seconde alimentation ;

   - un circuit régérateur de niveau comprenant une paire de diodes prélevant les signaux respectivement au drain de chaque transistor de la paire différentielle, caractériséen ce que les signaux transportés par les diodes sont appliqués respectivement sur le transistor bas d'une paire d'étages PUSH-PULL, dont le transistor haut reçoit directement le signal prélevé sur le drain du transistor opposé de la paire différentielle, la source des transistors bas des étages PUSH-PULL étant portée à la masse et le drain du transistor haut de ces étages étant porté au second potentiel d'alimentation $V_{DD}$, les sorties complémentaires amplifiées étant disponibles aux points milieux des étages PUSH-PULL.

2.        Circuit selon la revendication 1, caractérisé en ce qu'il est monolithiquement intégré sur un substrat en arséniure de gallium GaAs au moyen de transistors à effet de champ du type normalement pincés en l'absence de signal grille-source et de charges résistives.

0249287

FIG.1

0249287

FIG. 2

Office européen
des brevets

**RAPPORT DE RECHERCHE EUROPEENNE**

## DOCUMENTS CONSIDERES COMME PERTINENTS

| Categorie | Citation du document avec indication. en cas de besoin. des parties pertinentes | Revendication concernée | CLASSEMENT DE LA DEMANDE (Int Cl 4) |
|---|---|---|---|
| A | PATENT ABSTRACTS OF JAPAN, vol. 7, no. 267 (E-213)[1412], 29 novembre 1983; & JP-A-58 151 053 (MATSUSHITA DENKI SANGYO K.K.) 08-09-1983 | 1,2 | H 03 K 19/094 H 03 F 3/45 |
| | --- | | |
| A | EP-A-0 167 076 (HONEYWELL INC.) * Figures 1,2,5; page 6, lignes 4-13 * | 1,2 | |
| | --- | | |
| A | EP-A-0 153 774 (LABORATOIRES D'ELECTRONIQUE ET DE PHYSIQUE APPLIQUE) * Figures 1,2; résumé * | 1,2 | |
| | --- | | |
| A | US-A-4 161 040 (T. SATOH) * Figure 2; colonne 4, lignes 15-18 * | 1 | |
| | ----- | | |

DOMAINES TECHNIQUES RECHERCHES (Int Cl 4)

H 03 K
H 03 F

Le present rapport de recherche a été établi pour toutes les revendications

| Lieu de la recherche | Date d'achévement de la recherche | Examinateur |
|---|---|---|
| LA HAYE | 18-09-1987 | TYBERGHIEN G.M.P. |